Europäisches Patentamt

European Patent Office

Office européen des brevets

(19)

(11)  EP 0 998 037 B1

(12)  **FASCICULE DE BREVET EUROPEEN**

(45) Date de publication et mention
de la délivrance du brevet:
**15.12.2004  Bulletin 2004/51**

(51) Int Cl.[7]: **H03H 9/02**

(21) Numéro de dépôt: **99402626.8**

(22) Date de dépôt: **22.10.1999**

(54) **Filtre faibles pertes à ondes acoustiques de surface sur substrat de quartz de coupe optimisée**

Verlustarmes Oberflächenwellenfilter auf einem schnittoptimierten Quarzsubstrat

Low loss surface acoustic wave filter on a cut-optimised quartz substrate

(84) Etats contractants désignés:
**DE FI FR GB IT SE**

(30) Priorité: **30.10.1998  FR 9813665**

(43) Date de publication de la demande:
**03.05.2000  Bulletin 2000/18**

(73) Titulaire: **Thales**
**75008 Paris (FR)**

(72) Inventeurs:
• **Ballandras, Sylvain,**
**Thomson-CSF Propriété Intel.**
**94117 Arcueil Cédex (FR)**
• **Solal, Marc,**
**Thomson-CSF Propriété Intellectuelle**
**94117 Arcueil Cédex (FR)**
• **Briot, Emmanuelle,**
**Thomson-CSF Propriété Intellec.**
**94117 Arcueil Cédex (FR)**

(56) Documents cités:
**US-A- 4 323 809**

**Description**

Le domaine de l'invention est celui des dispositifs à ondes acoustiques et notamment celui des filtres ou des résonateurs, réalisés à la surface d'un substrat en matériau piézo-électrique.

Le choix d'un matériau et de sa coupe pour réaliser un dispositif à ondes acoustiques de surface est fait en général suivant deux critères : le coefficient de couplage piézo-électrique qui caractérise la bande relative maximale que l'on sait réaliser et le comportement du matériau en fonction de la température. En effet, lorsque la température varie, le matériau se dilate et ses coefficients élastiques varient résultant en des variations de la vitesse de propagation des ondes de surface et donc de la fréquence des dispositifs.

Le quartz est un matériau utilisé depuis très longtemps pour les filtres à ondes de surface. La coupe utilisée en général est la coupe dite ST (MB. Schultz, B.J. Matzinger, M.G. Holland, « Température dependence of surface acoustic wave velocity on α quartz », Journal of Applied Physics, Vol. 41, n° 7, pp. 2755-2765, (1970)). Les angles de coupe φ, θ et ψ sont définis selon la norme IEEE (Standard on piezoelectricity Std 176-1949, Proc. IRE, vol. 37, pp. 1378-1395 (1949)).

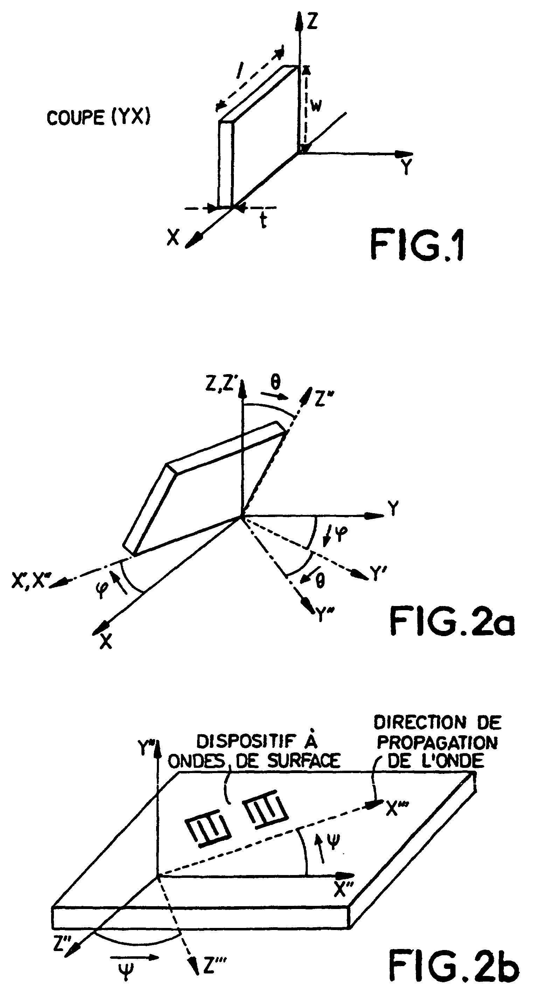

Pour éviter les ambiguïtés sur la définition des angles de coupes, on rappelle ci-dessous la définition de ces angles. Les axes X, Y et Z sont les axes cristallographiques du cristal. Le cristal choisi est un cristal dit « quartz gauche », et est caractérisé par le signe des constantes piézo-électriques $e_{11}$ et $e_{14}$. Le « quartz gauche » est tel que $e_{11}$ est positif et $e_{14}$ est négatif. La figure 1 montre une plaque de coupe (YX), c'est-à-dire que la normale au plan de coupe est l'axe Y et que la direction de propagation est l'axe X. On définit sur cette figure les directions w (suivant la largeur de la plaque), I (suivant sa longueur, donc la direction de propagation), et t (perpendiculaire à la plaque). Une coupe et un angle de propagation sont définis en partant de la coupe (YX) et en appliquant trois rotations successives. La rotation autour de w étant d'un angle φ, la rotation autour de I d'un angle θ et celle autour de t d'un angle ψ. La propagation se fait suivant la direction I de la plaque tournée. Le plan de coupe est donc défini entièrement par les deux premiers angles φ et θ (figure 2a) alors que le troisième ψ définit une direction particulière dans ce plan et donc pour les ondes de surface la direction de propagation utilisée (figure 2b).

On rappelle ci-dessous les angles définissant différentes coupes utilisées couramment pour les filtres à ondes de volume :

coupe BT : φ = 0, θ = -49°
coupe AT : φ = 0, θ = +35°
coupe SC : φ = -22,4°, θ = +33,8 °

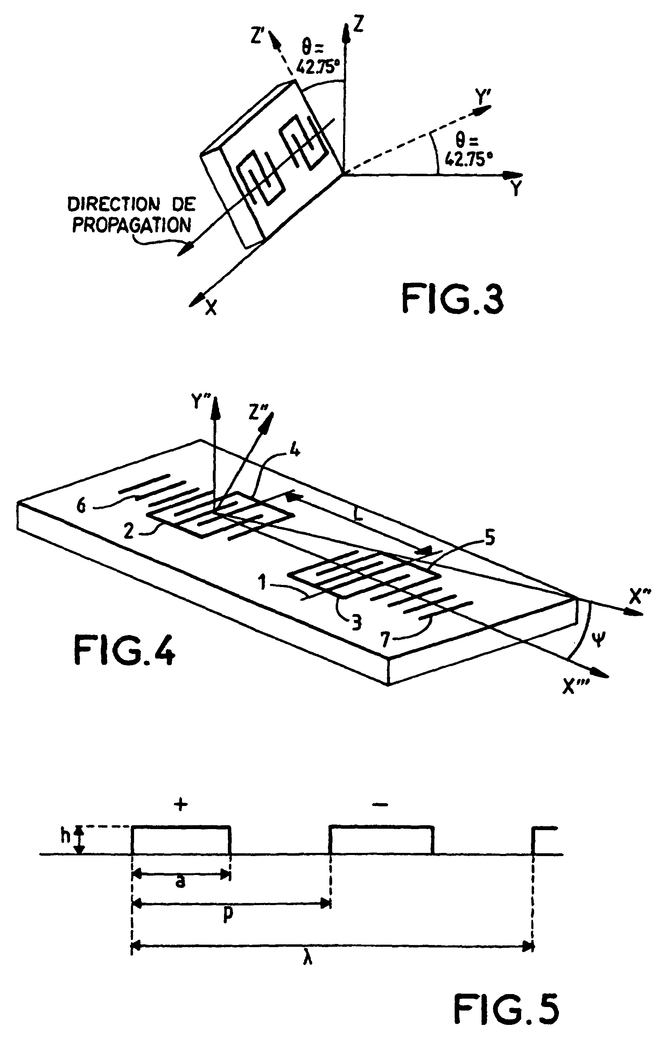

La coupe ST utilisée habituellement pour les dispositifs à ondes de surface est définie par les angles φ = 0°, θ = 42.75° et ψ = 0°. Cette coupe est décrite figure 3. Le repère d'axe initial est (XYZ), il devient après la première rotation (X'Y'Z') et (X"Y"Z") après la deuxième rotation et (X'''Y'''Z''') après la troisième rotation.

Un dispositif similaire est connu p.ex. du document US 4323809.

Cette coupe à simple rotation présente l'avantage d'avoir, pour les ondes de Rayleigh, une variation de la fréquence avec la température parabolique avec un point d'inversion à environ vingt cinq degrés Celsius (25°C), c'est-à-dire souvent au milieu de la gamme de température de fonctionnement pour les filtres. Le coefficient de couplage pour cette coupe est relativement faible (environ 0,12 %).

Si l'on dépose un matériau comme par exemple de l'aluminium pour notamment réaliser le transducteur générateur d'ondes acoustiques de surface à la surface du substrat, la température d'inversion change. En effet, pour compenser cet effet et garder une température d'inversion proche de 25°C, on change légèrement la coupe, ce qui amène à utiliser des coupes à partir de θ = 30° jusqu'à θ = 42°. Ces coupes présentent toutes des caractéristiques très proches à part la vitesse de propagation des ondes et le point d'inversion de leur loi fréquence-température.

Depuis quelques années, on réalise de plus en plus de filtres à faibles pertes d'insertion. Pour diminuer les pertes d'insertion, on utilise souvent la réflexion de l'onde de surface sur des électrodes. Le plus souvent, le matériau utilisé pour les électrodes est l'aluminium. Les filtres qui utilisent ces réflexions sont par exemple des filtres à résonateurs ou à transducteurs unidirectionnels de type DART ou SPUDT. Le coefficient de réflexion sur une électrode est une caractéristique très importante pour la conception. En effet, plus ce coefficient est grand, plus il sera facile de réaliser des pertes faibles dans une petite taille de puce. D'autre part, on réalise aussi des résonateurs à ondes acoustiques de surface qui utilisent d'autres types de réflecteurs tels des réseaux gravés ou plus souvent des réseaux de traits métallisés pour former des cavités. Pour ce type de dispositif également, le coefficient de réflexion est une caractéristique importante, un fort coefficient de réflexion permettant une cavité avec moins de pertes dans la même taille et donc améliorant le coefficient de qualité du résonateur.

Il est à noter néanmoins que lorsque l'on conçoit un dispositif, le coefficient de réflexion est limité par l'épaisseur maximale des électrodes qu'il est possible de réaliser. Par ailleurs, la sensibilité aux incertitudes technologiques (épaisseur de métallisation, largeur de trait) est d'autant plus forte que l'épaisseur de métallisation est forte, ce qui limite l'épaisseur utilisable en pratique.

Dans ce contexte, l'invention a pour objet un dispositif à ondes acoustiques de surface utilisant un substrat de quartz et des centres de réflexion pour lesquels le coefficient de réflexion utilisé est amélioré, tout en conservant les autres propriétés du matériau et ce par un choix optimisé de la coupe de quartz utilisée comme substrat piézo-électrique.

Plus précisément, l'invention a pour objet un dispositif à ondes acoustiques de surface, comprenant :

- un substrat en quartz ayant une surface de propagation des ondes acoustiques de surface ;
- des moyens pour créer des centres de transduction et des centres de réflexion, sur ledit substrat ;

le substrat ayant un plan de coupe (X", Z") défini par rapport au plan de coupe (X, Z) et dans un repère (X", Y", Z"), si X, Y, Z sont les axes cristallographiques du quartz, la direction de propagation des ondes étant définie selon un axe X''', un premier plan de coupe (X', Z') étant défini par rotation d'un angle φ autour de l'axe Z du plan (X, Z) de manière à définir un premier repère (X', Y', Z') avec un axe Z' confondu avec l'axe Z, un second plan de coupe (X", Z") étant défini par rotation d'un angle θ autour de l'axe X', du plan (X', Z') de manière à définir un second repère (X", Y", Z") avec l'axe X" confondu avec l'axe X', la direction de propagation selon l'axe X''' étant définie par rotation d'un angle ψ de l'axe X", dans le plan (X", Z") autour de l'axe Y", caractérisé en ce que :

$$- 60° \leq \varphi \leq 0°$$

θ est compris dans une plage de $\pm$ 40° autour de -40°.cos (3φ)
ψ est compris dans une plage de $\pm$ 22,5° autour de 35°+10°.sin (3φ)

Selon une première variante, tous les centres de transduction et tous les centres de réflexion peuvent appartenir à un même jeu d'électrodes interdigitées.

Selon une seconde variante de l'invention, certains centres de réflexion peuvent appartenir à un réseau séparé d'électrodes.

Selon une troisième variante de l'invention, le dispositif peut également comprendre des centres de réflexion issus d'un réseau gravé dans le substrat de quartz.

Avantageusement, les métallisations utilisées dans un dispositif selon l'invention sont en aluminium.

Selon une variante de l'invention, le dispositif à ondes acoustiques de surface peut être un filtre unidirectionnel de type SPUDT ou RSPUDT.

La coupe ST du quartz actuellement retenue offre des performances satisfaisantes en terme de coefficient de couplage, de courbe de variation de fréquence avec la température mais l'introduction puis la généralisation d'éléments réflecteurs dans les nouveaux types de filtre génèrent une contrainte supplémentaire rendant la coupe ST relativement moins intéressante lorsque l'on s'attache au coefficient de réflexion de réflecteur notamment en aluminium.

Les paramètres physiques développés dans la description ci-après montreront qu'il existe sur quartz un domaine de coupes présentant des propriétés équivalentes en dérive en température et coefficient de couplage mais présentant des coefficients de réflexion plus forts des éléments réflecteurs. L'utilisation d'une de ces coupes permet donc de réaliser un dispositif à ondes de surface utilisant des réflecteurs, présentant des avantages par rapport au dispositif équivalent sur une coupe ST.

Par ailleurs, il peut être particulièrement avantageux de définir un sous-ensemble de coupes de quartz pour lesquelles le coefficient de température de la fréquence du 1er ordre est faible, typiquement compris entre -10 ppm/°K et +10 ppm/°K, et un angle du flux également faible, typiquement compris entre -5° et +5°. La première condition conduit à l'obtention d'une température d'inversion de la loi fréquence-température proche de 25°C, ce qui est pratiquement recherché.

La seconde condition permet une optimisation du fonctionnement des dispositifs à ondes acoustiques de surface dans une taille la plus faible possible (pas de décalage des transducteurs pour rattraper ledit angle de flux d'énergie).

En effet, pour les dispositifs à ondes acoustiques de surface :

$$\Delta f/fo = CTF_1 (T-To) + CTF_2(T-To)^2$$

si

$CTF_1$ : coefficient du premier ordre

CTF$_2$ : coefficient du second ordre

To est la température de calcul des coefficients du premier et second ordre (en général 25°C).

$\Delta$f correspondant à la variation de fréquence induite pour une température courante de 298°K ; la température d'inversion est obtenue en résolvant l'équation d ($\Delta$f/fo) / dT = 0

ce qui correspond à une température d'inversion

$$T = To - \frac{CTF1}{2CTF_2}$$

avec CTF$_2$ voisin de -50 ppb/°K$^2$, par exemple
et CTF$_1$ voisin de -1 ppm/°K, par exemple

on obtient une température d'inversion

$$T = To - 10°K$$

L'invention sera mieux comprise et d'autres avantages apparaîtront à la lecture de la description qui va suivre donnée à titre non limitatif et grâce aux figures annexées parmi lesquelles :

- la figure 1 illustre une plaque de quartz de coupe YX :
- les figures 2a et 2b illustrent la définition d'une coupe et d'un angle de propagation par rapport à la coupe YX ;
- la figure 3 illustre une coupe ST de quartz utilisée dans des dispositifs de l'art connu ;
- la figure 4 est une vue en perspective d'un dispositif à ondes acoustiques de surface illustrant des transducteurs interdigités ainsi que des réseaux d'électrodes sur un substrat de quartz de coupe selon l'invention ;
- la figure 5 illustre la géométrie d'électrodes utilisées dans un dispositif à ondes acoustiques de surface ;
- les figures 6a à 6g illustrent des courbes d'isovaleurs de coefficient de réflexion en fonction de l'angle de coupe $\theta$ et de la propagation $\psi$, pour respectivement des angles $\varphi$ = 0, -10, -20, -30, -40, -50, -60 ;
- les figures 7a à 7g illustrent les courbes d'isovaleurs des températures d'inversion égales à 25°C , en fonction des angles $\theta$ et $\psi$ pour respectivement des angles $\varphi$ = 0, -10, -20, -30, -40, -50, -60 ;
- la figure 8 illustre la répartition spatiale des réflecteurs et des transducteurs utilisée dans un filtre réalisé à la surface d'un substrat de quartz de coupe définie par les angles $\varphi$ = -20°, $\theta$ = - 35,5° et $\psi$ = +20° ;
- la figure 9 schématise les éléments électriques permettant l'accord du filtre réalisé sur la coupe définie par les angles $\varphi$ = -20°, $\theta$ = -35,5° et $\psi$ = +20° ;
- la figure 10 illustre la réponse en fréquence du filtre réalisé sur la coupe définie par les angles $\varphi$ = -20°, $\theta$ = -35,5° et $\psi$ = +20° ;
- la figure 11 illustre l'évolution de la fréquence en fonction de la température pour le filtre réalisé sur la coupe définie par les angles $\varphi$ = -20°, $\theta$ = -35,5° et $\psi$ = +20°

La figure 4 illustre de manière très schématique un exemple de dispositif à ondes acoustiques de surface, selon l'invention et comprenant des centres de transduction et des centres de réflexion réalisés grâce à des électrodes métalliques. Plus précisément, ce dispositif comprend deux transducteurs à électrodes interdigitées 2, 3, 4, 5 et deux réflecteurs 6 et 7 constitués de réseaux de traits. La direction de propagation est la direction X''' du substrat après rotation et c'est donc l'axe X'' du plan de coupe défini par les angles $\varphi$ et $\theta$ tourné d'un angle $\psi$.

Pour chaque plan de coupe définissant un substrat de quartz donné, il existe une direction privilégiée de propagation des ondes acoustiques de surface pour laquelle les performances du dispositif sont optimisées.

Cette direction de propagation est définie par l'angle $\Psi$ :

Selon l'invention $\Psi$ = 35° + 10°.sin (3$\varphi$).

Nous allons ci-après, pour différentes configurations de plans de coupe et de direction de propagation des ondes acoustiques, donner les valeurs :

- du coefficient de couplage $K_S^2$ représentatif de la bande relative maximale que l'on peut obtenir avec un dispositif et calculé comme le demi-écart relatif des vitesses des ondes de surface sur le substrat libre et le substrat métallisé ;
- du coefficient de réflexion R du réflecteur calculé en h/$\lambda$, si h est l'épaisseur de métal et $\lambda$ la longueur d'onde ;
- de l'angle de flux d'énergie $\eta$ (en degrés), qui est l'angle séparant le vecteur d'onde et le vecteur de Poynting de l'onde de surface ;

- du coefficient du premier ordre de la variation de la fréquence caractéristique du filtre en fonction de la température, au voisinage de la température ambiante (25°C) ;
- de la vitesse de propagation des ondes de surface V∞ ;
- du coefficient du second ordre de la variation de la fréquence caractéristique du filtre en fonction de la température, au voisinage de la température ambiante (25°C) ;
- de la température d'inversion de la courbe fréquence température qui est le sommet de la courbe fréquence température pour une épaisseur nulle. Pour minimiser les variations en fréquence d'un dispositif à ondes de surface, il faut choisir une coupe telle que cette température d'inversion soit proche du milieu de la gamme de température de fonctionnement.

Il est à noter que pour des électrodes de faible épaisseur, on peut considérer que la partie mécanique de R est proportionnelle à l'épaisseur de l'électrode h normalisée à la longueur d'onde. Un modèle simplifié basé sur les calculs de Datta et Hunsinger (S. Datta, B. Hunsinger, « First order reflexion coefficient of surface acoustic waves from thin strip overlays », Journal of Applied Physics, Vol. 50, n° 9, pp. 5661-5665 (1979)) permet d'estimer le coefficient de réflexion avec une bonne précision. Pour les coupes ST du quartz et pour des électrodes de largeur $\lambda/4$, R est de l'ordre de 0,5 h/$\lambda$. Pour des électrodes de plus fortes épaisseurs, il se produit un effet dit de « stockage d'énergie » et le calcul de Datta et Hunsinger n'est plus aussi fiable (P. Ventura, J. Desbois, L. Boyer, « A mixed FEM/analytical model of electrode mechanical perturbation for SAW and PSAW propagation », Proc. of the 1993 IEEE Ultrasonics Symposium, IEEE cat. n° 93 CH 3301-9, pp. 205-208). Cependant, les calculs montrent que l'on peut considérer que ce calcul permet de classer correctement les coupes en ce qui concerne leur coefficient de réflexion mécanique. D'autre part, les propriétés mécaniques du quartz et de l'aluminium étant voisines, on peut considérer que les coupes choisies pour le fort coefficient de réflexion sur une bande d'aluminium présenteront aussi un fort coefficient de réflexion sur un sillon gravé dans le quartz.

Les résultats des calculs (voir tableau II) montrent que pour les zones de coupe définies dans l'invention, le coefficient de couplage est toujours au moins du même ordre de grandeur que le coefficient de couplage sur la coupe ST du quartz. D'autre part, il existe pour toutes les coupes de la zone, un ou des angles de propagation $\psi$ pour lesquels la température d'inversion est d'environ 25°C.

Le tableau I récapitule et référence différents plans de coupe repérés par les angles $\varphi$ et $\theta$, et associés à une direction de propagation repérée par l'angle $\psi$. L'angle $\psi$ et la coupe $\theta$ sont choisis pour la coïncidence de forts coefficients de réflexion, d'un angle de flux d'énergie proche de 0° et pour leur température d'inversion proche de 25°C.

Le tableau II récapitule les paramètres physiques précités correspondant aux coupes du tableau I.

TABLEAU I

| $\varphi$ (degrés) | $\theta$ (degrés) | $\psi$ (degrés) | Référence |
|---|---|---|---|
| - 60 | + 45.5 | + 23 | (a) |
| - 50 | + 39 | + 20 | (b) |
| - 40 | + 35.5 | + 18 | (c) |
| - 30 | + 37 | +15 | (d) |
| - 30 | - 38 | + 18 | (e) |
| - 20 | - 35.5 | + 20 | (f) |
| - 10 | - 38.5 | + 22 | (g) |
| 0 | - 45 | + 24.75 | (h) |

TABLEAU II

| COUPE | (a) | (b) | (c) | (d) | (e) | (f) | (g) | (h) | ST |
|---|---|---|---|---|---|---|---|---|---|
| $K_s^2$(‰) | 1,47 | 1,57 | 1,46 | 1,33 | 1,24 | 1,37 | 1,51 | 1,3 | 1,16 |
| $R\propto$(h/$\lambda$) | 2,16 | 2,05 | 1,7 | 1,22 | 1,2 | 1,7 | 2,1 | 2,15 | 0,51 |
| angle de flux d'énergie $\eta$ (degrés) | -0,53 | 0,17 | 0,11 | 0,4 | 0,15 | 0,1 | 0,1 | 0,6 | 0 |
| coefficient du premier ordre de variation de la fréquence (ppm/°K) à $\frac{\Delta f}{\Delta T}$ 25 deg C | 0,33 | 1 | -0,02 | -0,7 | -0,5 | -0,04 | 0,31 | 0,61 | -0,06 |

TABLEAU II   (suite)

| COUPE | (a) | (b) | (c) | (d) | (e) | (f) | (g) | (h) | ST |
|---|---|---|---|---|---|---|---|---|---|
| V∞ (m.s$^{-1}$) | 3626 | 3548 | 3444 | 3324 | 3320 | 3444 | 3546 | 3625 | 3157 |
| coefficient du second ordre de variation de la fréquence (10$^{-9}$/°K2) à $\frac{\Delta^2 f}{\Delta T^2}$ 25 deg C | -49,7 | -47 | -45,6 | -40,7 | -43,2 | -44,1 | -47,8 | -50,4 | -40,1 |
| température en turn over $\theta_{tum}$ (°C) | 28,3 | 35,6 | 24,8 | 18,6 | 16,7 | 17,4 | 28 | 30,6 | 17,3 |

Il ressort du tableau II, que les plans de coupe associés à des directions de propagation privilégiées des ondes acoustiques préconisés dans la présente invention permettent d'accroître le coefficient de réflexion R tout en préservant les autres paramètres caractéristiques.

Rappelons encore qu'il existe des symétries pour les ondes de Rayleigh sur quartz telles que :

- (+φ, θ, +ψ) équivaut à (-φ, θ, -ψ) quel que soit le signe de θ
- (φ, θ, ψ) équivaut à (φ+120°, θ, ψ)
- (φ, θ, ψ) équivaut à (φ, θ+180°, ψ)
- (φ, θ, ψ) équivaut à (φ, θ, ψ+180°) excepté pour le coefficient de réflexion dont la phase sera inversée.

En combinant ces différentes symétries, on considère que les propriétés des ondes de Rayleigh sont décrites de façon unique pour le quartz dans les gammes d'angle suivantes :
-60° < φ < +60° -90° < θ < +90°, 0° < ψ < +90°

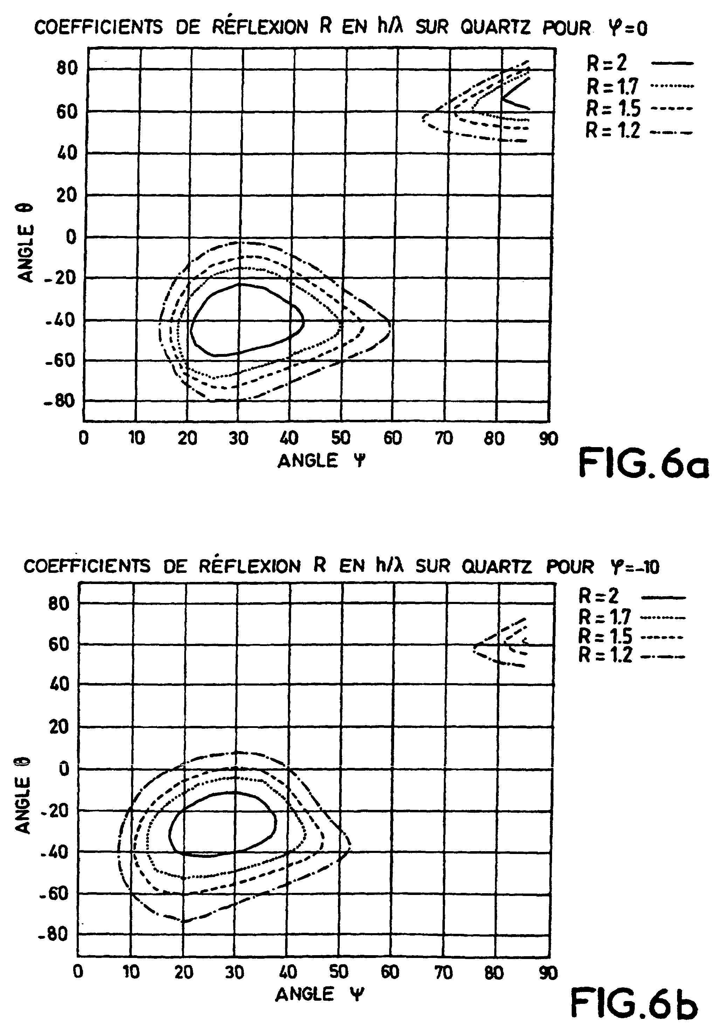

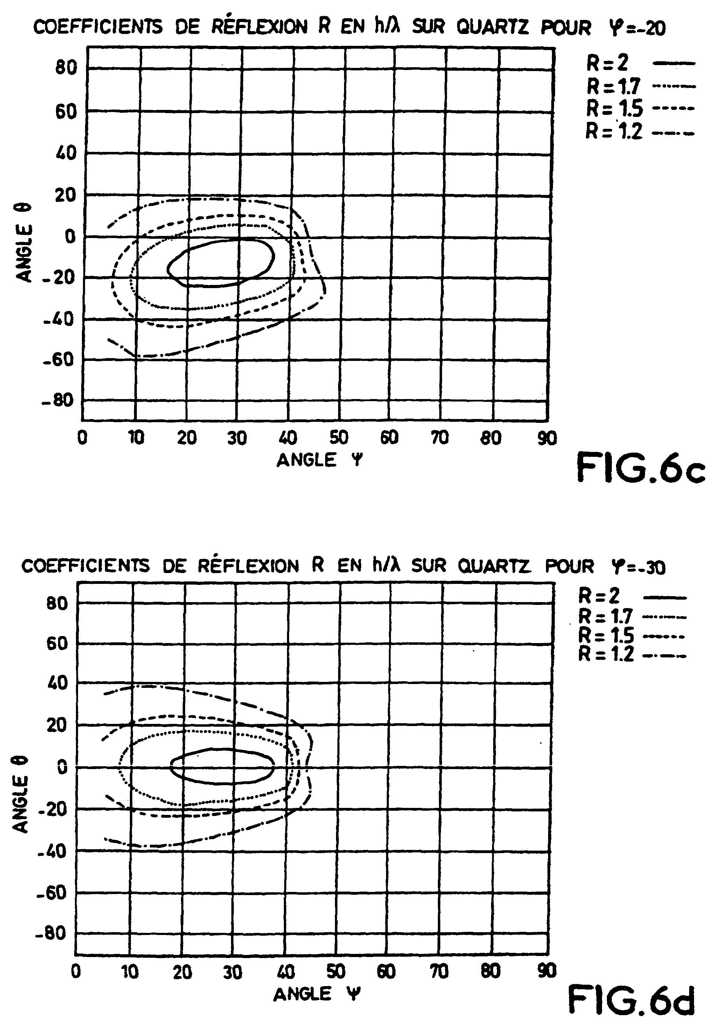

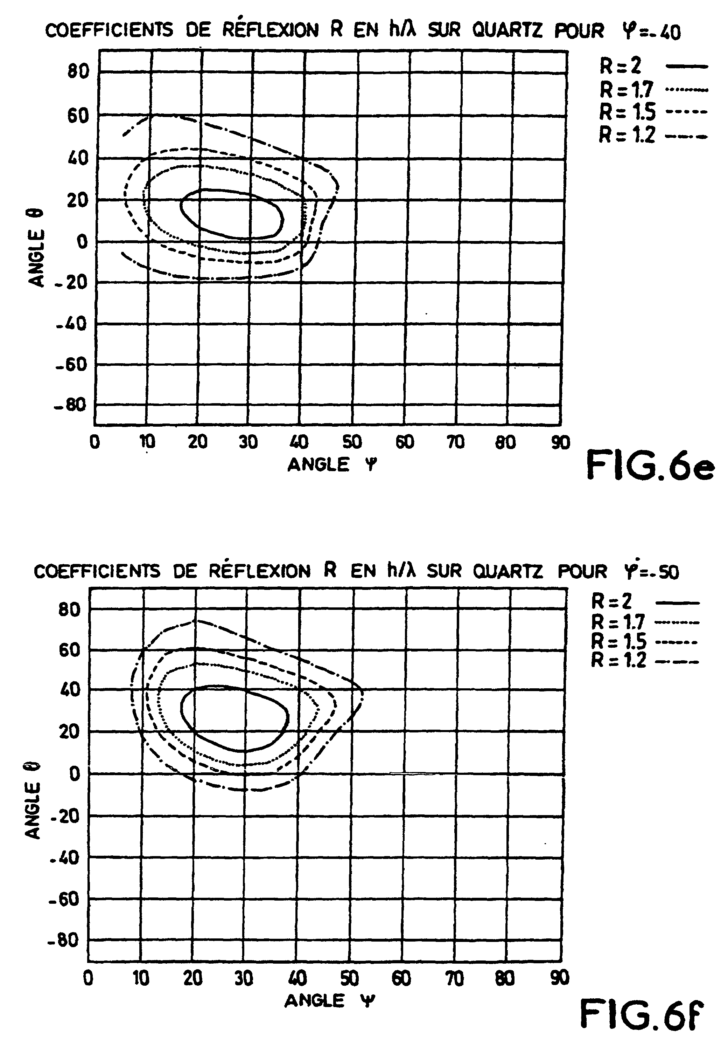

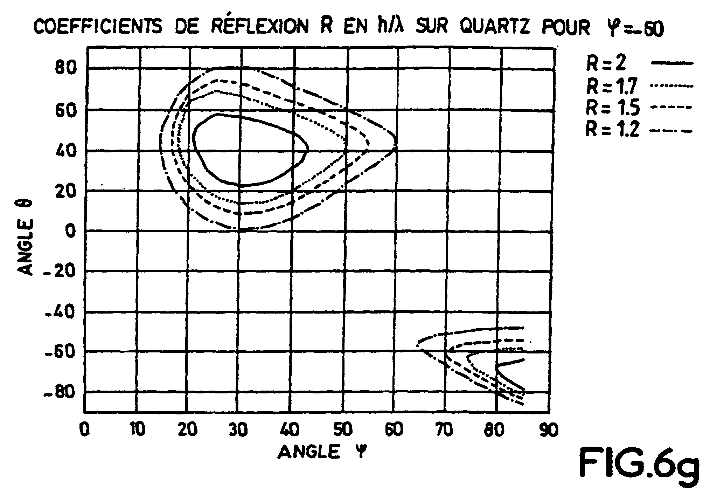

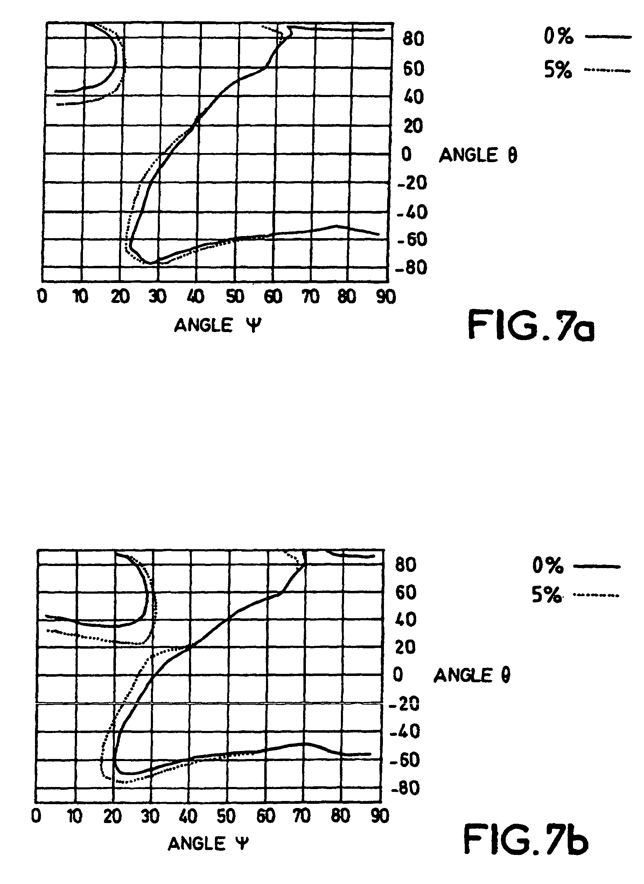

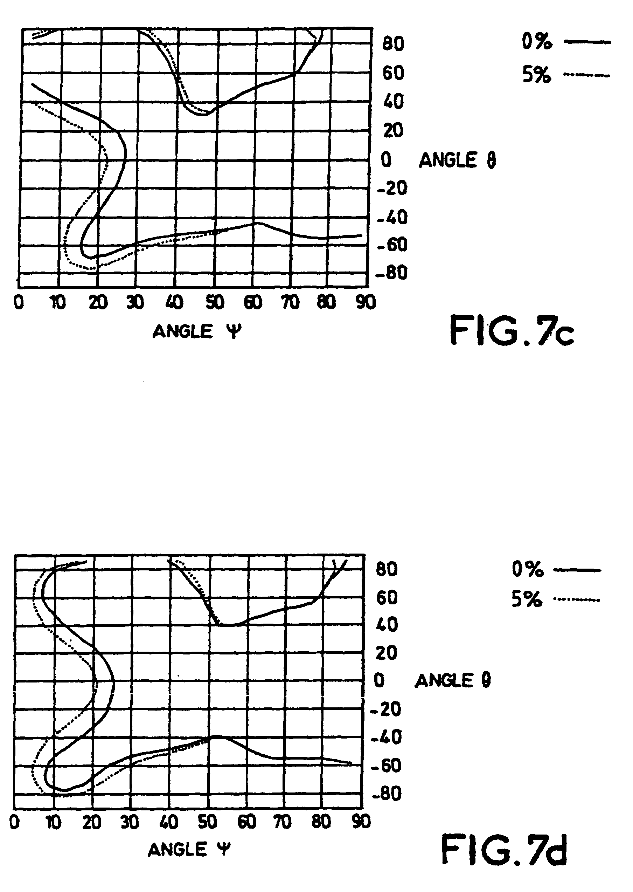

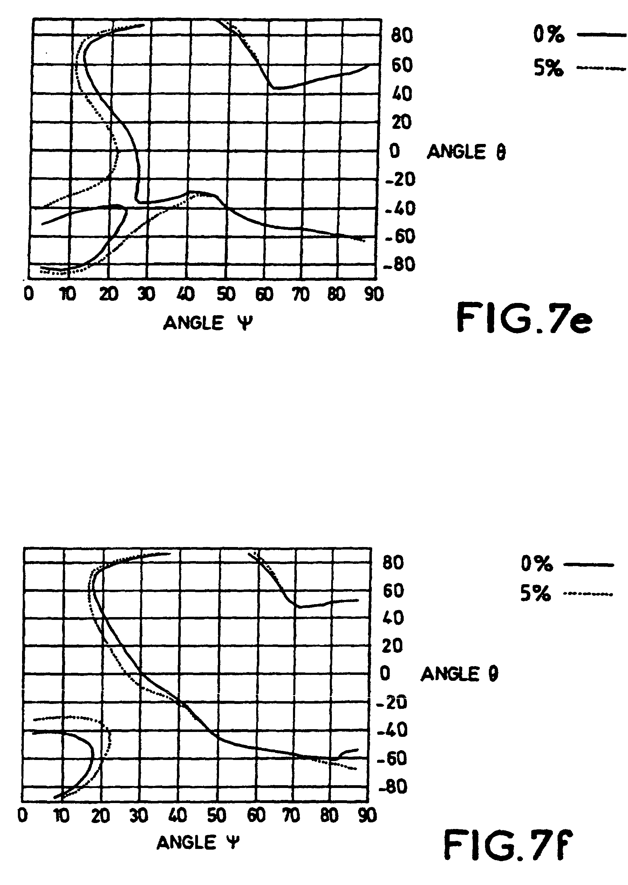

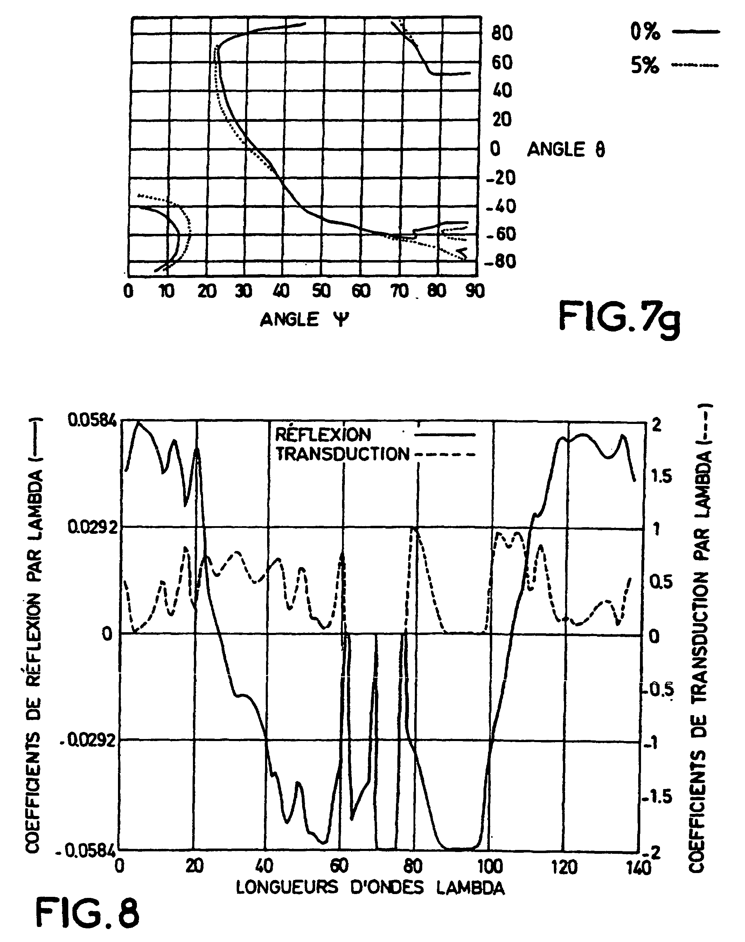

Les figures 6a à 6g illustrent les courbes d'isovaleurs de coefficient de réflexion sur un obstacle d'aluminium de faible épaisseur relative h/λ c'est-à-dire en considérant le rapport hauteur h sur longueur d'onde acoustique λ très inférieur au pourcent pour un rapport de métallisation par période a/p de 50% comme illustré en figure 5, calculé à l'aide du modèle simplifié basé sur les calculs de Datta et Hunsinger, en fonction de l'angle de coupe θ et de la direction de propagation ψ pour les différentes valeurs de l'angle de coupe φ concernées par les revendications (c'est-à-dire de 0° à -60° par pas de 10°). Ces courbes permettent de préciser graphiquement les zones à fort coefficient de réflexion R objet de l'invention. Pour toutefois réduire quelque peu les domaines angulaires concernés, on reporte sur les figures 7a à 7g les isovaleurs de température d'inversion égale à 25°C pour des épaisseurs de métallisation relatives λ nulle et égale à 5% avec a/p = 50% pour les mêmes valeurs d'angle. Cette dernière information concernant l'influence de l'épaisseur de métallisation ne peut être cependant utilisée qu'à titre informel car elle est issue d'un calcul théorique validé uniquement pour la coupe ST (E. Henry, S. Ballandras, E. Bigler, G. Marianneau, G. Martin, S. Camou, « Influence of metallization on temperature sensibility of saw devices » Proc. of the IEEE Ultrasonics Symp., pp. 221-226, 1997) et la coupe (f) donc à considérer avec la circonspection d'usage.

**Exemple de filtre réalisé sur une plaque de quartz, découpe selon l'invention**

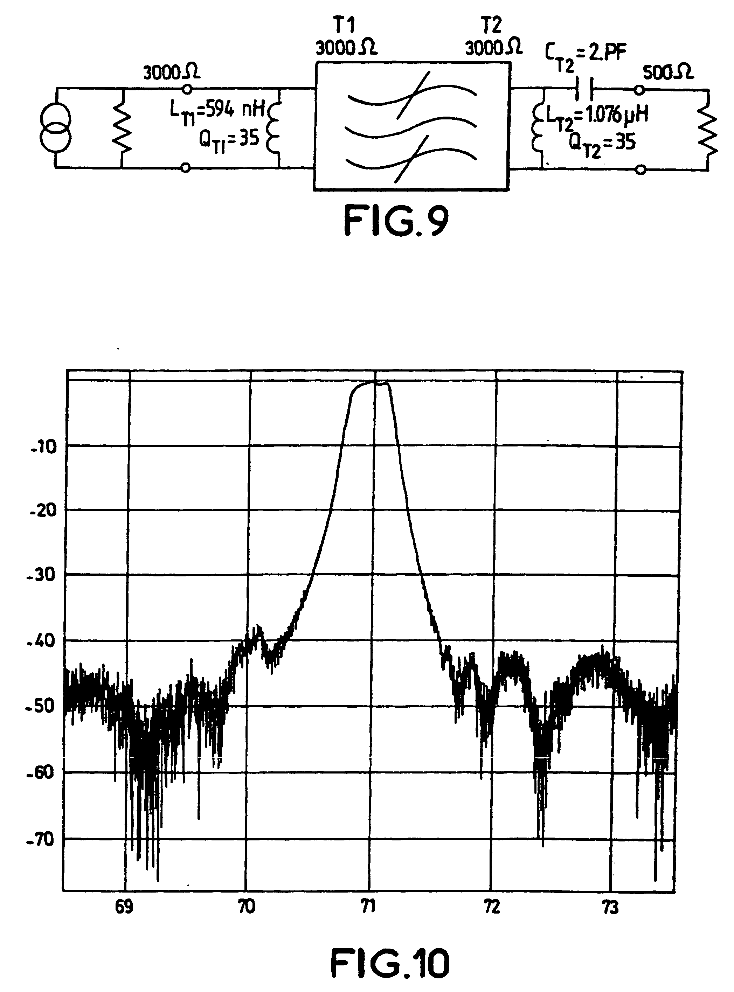

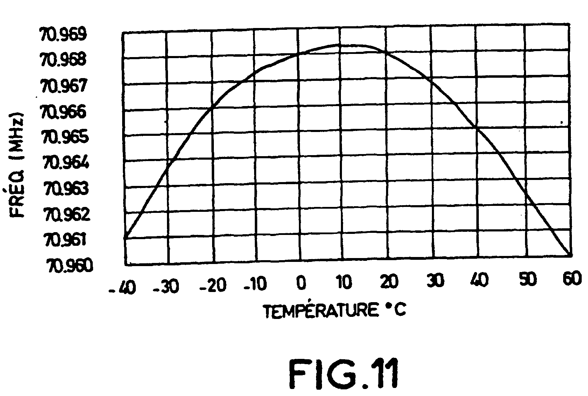

Une illustration de la mise en oeuvre pratique d'une des nouvelles coupes de quartz est présentée ci-après. Elle consiste en la fabrication d'un filtre de type DART résonnant conformément à la norme GSM et centré autour de la fréquence 71 MHz. Le filtre comprend donc deux transducteurs tous deux pondérés par suppression de sources ainsi que deux réseaux réflecteurs situés dans la cavité inter-transducteur, eux-mêmes séparés d'une distance d'un quart de longueur d'onde. Cette structure d'électrodes est fabriquée sur la coupe (f) dont on rappelle la définition (Coupe (YX*wlt*) -20,-35.5,+20) par dépôt d'aluminium gravé chimiquement. Les dimensions de la puce de cristal résultante permettent son encapsulation dans un boîtier 10×6 mm$^2$. L'intérêt de l'utilisation de la nouvelle coupe réside alors dans une réduction substantielle de l'épaisseur de métal nécessaire pour réaliser la partie réflectrice du DART résonant. En effet, celle-ci passe de 1400nm (14000 Å) (coupe ST) à 800nm (8000 Å) pour la nouvelle coupe, ce qui rend la fabrication du dispositif moins sujette aux défauts de fabrication d'origine purement technologique. La figure 8 montre la répartition spatiale des réflecteurs R (exprimée par longueur d'onde) et la répartition des transducteurs T normalisés, le coefficient d'un réflecteur élémentaire étant de 2,92 %, ce qui correspond à un maximum de 5,84 % par longueur d'onde. Le filtre, conçu pour fonctionner sur des impédances d'entrée $Z_{in}$ = 3000 Ω et de sortie $Z_{out}$ = 500 Ω (voir figure 9), est accordé à l'aide d'une self-inductance parallèle de 1.1 µH en entrée et d'un couple inductance parallèle - capacité série de valeur respective 600 nH et 2 pF en sortie. La courbe illustrée en figure 10 permet d'apprécier la qualité de la réponse électrique du filtre sur coupe (f), avec une réjection lointaine supérieure à 40 dB et des pertes dans la bande de l'ordre de -7.5 dB. On note cependant que l'on a du s'affranchir lors de la conception puis de la fabrication du filtre de la phase du coefficient de réflexion (inhérent à la plupart des nouvelles coupes) en décalant les réflecteurs par rapports aux transducteurs dans les cellules DART élémentaires, ladite phase étant estimée théoriquement à 162.4 degrés, ce qui signifie que l'onde réfléchie sur un réflecteur est déphasée de $\pm$ 162,4°-90° au lieu des -90° que l'on aurait eu sur quartz ST. Les deux directions de propagation ne sont alors plus équivalentes et il est nécessaire de décaler les centres de transduction et de réflexion dans les cellules DART pour en tenir compte. Finalement, la figure 11 montre que les ondes de Rayleigh, compte tenu de l'épaisseur relative de métallisation utilisée (h/$\lambda$ de l'ordre de 1.67 %), sont compensées des effets de température au voisinage de la température ambiante, permettant ainsi d'obtenir une loi fréquence température parabolique du filtre dont le point d'inversion se situe entre 10 et 20°C. On remarque que le coefficient de sensibilité à la température du second ordre est sensiblement supérieur à celui de la coupe ST (-50 ppb/°$K^2$ pour la coupe (f) contre -40 ppb/°$K^2$ pour la coupe ST) mais reste toutefois dans le même ordre de grandeur.

**Revendications**

1. Dispositif à ondes acoustiques de surface, comprenant :

   - un substrat en quartz ayant une surface de propagation des ondes acoustiques de surface ;
   - des moyens pour créer des centres de transduction et des centres de réflexion de ondes acoustiques ;

   le substrat ayant un plan de coupe (X", Z") défini par rapport au plan de coupe (X, Z) et dans un repère (X", Y", Z"), si X, Y, Z sont les axes cristallographiques du quartz, la direction de propagation des ondes étant définie selon un axe X"', un premier plan de coupe (X', Z') étant défini par rotation d'un angle $\varphi$ autour de l'axe Z, du plan (X, Z) de manière à définir un premier repère (X', Y', Z') avec un axe Z' confondu avec l'axe Z, un second plan de coupe (X", Z") étant défini par rotation d'un angle $\theta$ autour de l'axe X', du plan (X', Z') de manière à définir un second repère (X", Y", Z") avec l'axe X" confondu avec l'axe X', la direction de propagation selon l'axe X"' étant définie par rotation d'un angle $\psi$ de l'axe X", dans le plan (X", Z") autour de l'axe Y", **caractérisé en ce que** :

$$- 60° \leq \varphi \leq 0°$$

   $\theta$ est compris dans une plage de $\pm$ 40° autour de -40°.cos (3$\varphi$)
   $\psi$ est compris dans une plage de $\pm$ 22,5° autour de 35°+10°.sin (3$\varphi$).

2. Dispositif à ondes acoustiques de surface selon la revendication 1, **caractérisé en ce que**

$$- 60° \leq \varphi \leq 0°$$

   ($\theta$, $\psi$) étant définis de manière à ce que le coefficient du premier ordre de la variation de la fréquence en fonction de la température est compris entre -10 ppm/°K et +10 ppm/°K et l'angle de flux compris entre -5° et +5°.

3. Dispositif selon l'une des revendications 1 ou 2, **caractérisé en ce qu'**il comprend des électrodes interdigitées pour créer des centres de transduction et des centres de réflexion.

4. Dispositif selon l'une des revendications 1 ou 2, **caractérisé en ce qu'**il comprend en outre des réseaux d'électrodes pour créer des centres de réflexion.

5. Dispositif selon l'une des revendications 3 ou 4, **caractérisé en ce que** le substrat de quartz comprend localement des sillons gravés pour créer des centres de transduction.

6. Dispositif selon l'une des revendications 3 à 5, **caractérisé en ce que** les électrodes sont en aluminium.

**Patentansprüche**

1. Akustische Oberflächenwellenvorrichtung, die aufweist:

- ein Substrat aus Quarz mit einer Ausbreitungsfläche für die akustischen Oberflächenwellen;
- Mittel, um Wandlungszentren und Reflexionszentren von akustischen Wellen zu bilden;

wobei das Substrat eine Schnittebene (X", Z") aufweist, die bezüglich der Schnittebene (X, Z) und in einem Koordinatensystem (X", Y", Z") definiert ist, wenn X, Y, Z die kristallographischen Achsen des Quarzes sind, wobei die Ausbreitungsrichtung der Wellen gemäß einer Achse X''' definiert ist, wobei eine erste Schnittebene (X', Z') durch Drehung der Ebene (X, Z) um einen Winkel φ um die Achse Z, definiert ist, um ein erstes Koordinatensystem (X', Y', Z') mit einer Achse Z' zu definieren, die mit der Achse Z zusammenfällt, wobei eine zweite Schnittebene (X", Z") durch Drehung der Ebene (X', Z') um einen Winkel θ um die Achse X' definiert ist, um ein zweites Koordinatensystem (X", Y", Z") zu definieren, wobei die Achse X" mit der Achse X' zusammenfällt, wobei die Ausbreitungsrichtung gemäß der Achse X''' durch Drehung der Achse X" in der Ebene (X", Z") um einen Winkel ψ um die Achse Y" definiert ist, **dadurch gekennzeichnet, dass** gilt:

$$-60° \leq \varphi \leq 0°$$

θ liegt in einem Bereich von ±40° um -40°.cos (3φ)
ψ liegt in einem Bereich von ±22,5° um 35°+10°.sin (3φ).

2. Akustische Oberflächenwellenvorrichtung nach Anspruch 1, **dadurch gekennzeichnet, dass** gilt:

$$- 60° \leq \varphi \leq 0°$$

wobei (θ, ψ) so definiert sind, dass der Koeffizient der ersten Ordnung der Frequenzvariation in Abhängigkeit von der Temperatur zwischen -10 ppm/°K und +10 ppm/°K liegt, und der Flusswinkel zwischen -5° und +5° liegt.

3. Vorrichtung nach einem der Ansprüche 1 oder 2, **dadurch gekennzeichnet, dass** sie ineinander verschachtelte Elektroden aufweist, um Wandlungsund Reflexionszentren zu bilden.

4. Vorrichtung nach einem der Ansprüche 1 oder 2, **dadurch gekennzeichnet, dass** sie außerdem Elektrodennetze aufweist, um Reflexionszentren zu bilden.

5. Vorrichtung nach einem der Ansprüche 3 oder 4, **dadurch gekennzeichnet, dass** das Quarzsubstrat lokal eingravierte Rillen aufweist, um Wandlungszentren zu bilden.

6. Vorrichtung nach einem der Ansprüche 3 bis 5, **dadurch gekennzeichnet, dass** die Elektroden aus Aluminium sind.

**Claims**

1. Surface acoustic wave device, comprising :

- a quartz substrate having a surface for propagating the surface acoustic waves;
- means for creating acoustic wave transduction centres and reflection centres;

the substrate having a cut plane(X",Z") defined with respect to the cut plane (X,Z) and in a reference frame (X",Y",Z"), if X, Y and Z are the crystallographic axes of the quartz, the direction of propagation of the waves being defined along an axis X''', a first cut plane (X',Z') being defined by rotation through an angle φ about the Z axis, of the (X,Z) plane so as to define a first reference frame (X',Y',Z') with an axis Z' coincident with the Z axis, a second cut plane (X",Z") being defined by rotation through an angle θ about the X' axis, of the (X',Z') plane, so as to define a second reference frame (X",Y",Z") with the X" axis coincident with the X' axis, the direction of propagation along the X''' axis being defined by rotation through an angle ψ of the X" axis, in the (X",Z") plane about the Y" axis, **characterized in that** :

$$- 60° \leq \varphi \leq 0°;$$

θ lies within a ± 40° range about -40° × cos(3φ);
ψ lies within a ± 22.5°range about 35° + 10° × sin (3φ).

2. Surface acoustic wave device according to Claim 1, **characterized in that**:

$$-60° \leq \varphi \leq 0°;$$

(θ, ψ) being defined so that the first-order coefficient of the variation in the frequency as a function of temperature lies between -10 ppm/K and + 10 ppm/K and the flux angle lies between -5° and +5°.

3. Device according to either of Claims 1 and 2, **characterized in that** it includes interdigitated electrodes in order to create transduction centres and reflection centres.

4. Device according to either of Claims 1 and 2, **characterized in that** it furthermore includes arrays of electrodes in order to create reflection centres.

5. Device according to either of Claims 3 and 4, **characterized in that** the quartz substrate includes locally etched grooves in order to create transduction centres.

6. Device according to one of Claims 3 to 5, **characterized in that** the electrodes are made of aluminium.

COUPE (YX)

# FIG.1

# FIG.2a

DISPOSITIF À
ONDES DE SURFACE

DIRECTION DE
PROPAGATION
DE L'ONDE

# FIG.2b

FIG.3

FIG.4

FIG.5

COEFFICIENTS DE RÉFLEXION R EN h/λ SUR QUARTZ POUR Ψ=0

R = 2 ——
R = 1.7 ········
R = 1.5 - - - -
R = 1.2 —·—·

ANGLE θ

ANGLE Ψ

## FIG.6a

COEFFICIENTS DE RÉFLEXION R EN h/λ SUR QUARTZ POUR Ψ=-10

R = 2 ——
R = 1.7 ········
R = 1.5 - - - -
R = 1.2 —·—·

ANGLE θ

ANGLE Ψ

## FIG.6b

COEFFICIENTS DE RÉFLEXION R EN h/λ SUR QUARTZ POUR Ψ=-20

R=2 ———
R=1.7 ———
R=1.5 ———
R=1.2 —·—

ANGLE θ

ANGLE Ψ

**FIG.6c**

COEFFICIENTS DE RÉFLEXION R EN h/λ SUR QUARTZ POUR Ψ=-30

R=2 ———
R=1.7 ———
R=1.5 ———
R=1.2 —·—

ANGLE θ

ANGLE Ψ

**FIG.6d**

COEFFICIENTS DE RÉFLEXION R EN h/λ SUR QUARTZ POUR Ψ = -40

R = 2 ———
R = 1.7 ···········
R = 1.5 - - - - -
R = 1.2 —-—-—

ANGLE θ

ANGLE Ψ

FIG.6e

COEFFICIENTS DE RÉFLEXION R EN h/λ SUR QUARTZ POUR Ψ = -50

R = 2 ———
R = 1.7 ———
R = 1.5 ———
R = 1.2 - - - -

ANGLE θ

ANGLE Ψ

FIG.6f

14

COEFFICIENTS DE RÉFLEXION R EN h/λ SUR QUARTZ POUR Ψ=-60

FIG.6g

FIG.7a

FIG.7b

FIG.7c

FIG.7d

**FIG.7e**

**FIG.7f**

FIG.7g

FIG.8

FIG.9

FIG.10

FIG.11